# EUROPEAN PATENT APPLICATION

(11) **EP 4 804 741 A1**
(43) Date of publication of application: **09.09.2026**
(21) Application number: 24884631.3
(22) Date of filing: 28.10.2024
(51) Int. Cl.: H05K 5/02

(54) **HINGE MECHANISM AND ELECTRONIC DEVICE**

(30) Priority: 03.11.2023 CN 202311467166
(71) Applicant: Vivo Mobile Communication Co., Ltd., Dongguan, Guangdong 523863 (CN)
(72) Inventor: CAI, Yongfa, Dongguan, Guangdong 523863 (CN)
(74) Representative: Conti, Marco
(86) International application number: PCT/CN2024/127625
(87) International publication number: WO 2025/092628

(57) **Abstract**

This application discloses a hinge mechanism and an electronic device, and belongs to the field of communication technologies. The hinge mechanism includes a base, a first swing arm, and a frame connecting member. The first swing arm includes a first swing arm body, a first rotating connection portion, and a second rotating connection portion. The first rotating connection portion and the second rotating connection portion are disposed at two ends of the first swing arm body, the first rotating connection portion is rotatably connected to the base, and the second rotating connection portion is rotatably connected to the frame connecting member. A first slide groove is provided in the frame connecting member, and the first slide groove is provided with a component along a first direction, where the first direction is a direction perpendicular to a plane on which the first swing arm body is located. The second rotating connection portion is a cylindrical structure, and the second rotating connection portion is located in the first slide groove and is in movable fit with the first slide groove. In a process in which the first swing arm rotates relative to the base, the second rotating connection portion slides and rotates in the first slide groove. The electronic device includes a first device body, a second device body, and the hinge mechanism.

## Description

### CROSS-REFERENCE TO RELATED APPLICATIONS

This application claims priority to Chinese Patent Application No. 202311467166.X, filed with the China National Intellectual Property Administration on November 3, 2023 and entitled ''Hinge Mechanism and Electronic Device'', which is incorporated herein by reference in its entirety.

### TECHNICAL FIELD

This application belongs to the field of communication technologies, and specifically relates to a hinge mechanism and an electronic device.

### BACKGROUND

With the development of science and technology, people's dependence on electronic devices is increasing. To improve portability and comfort of use of electronic devices, an application range of the foldable electronic devices is becoming wider.

In the related art, a foldable electronic device is folded and unfolded via a hinge mechanism. The hinge mechanism includes a base and a swing arm, and the swing arm is rotatably connected to the base. In a process of switching the hinge mechanism from an unfolded state to a folded state, the swing arm rotates by a certain angle relative to the base. A mating area between the swing arm and the base is small; stability of the swing arm is reduced, and the swing arm is prone to problems such as jamming, breakage, and deformation. As a result, folding reliability of the hinge mechanism is reduced.

### SUMMARY

An objective of embodiments of this application is to provide a hinge mechanism and an electronic device, to resolve a problem of low folding reliability of the hinge mechanism in the related art.

According to a first aspect, an embodiment of this application provides a hinge mechanism, including a base, a first swing arm, and a frame connecting member.

The first swing arm includes a first swing arm body, a first rotating connection portion, and a second rotating connection portion, the first rotating connection portion and the second rotating connection portion are disposed at two ends of the first swing arm body, the first rotating connection portion is rotatably connected to the base, and the second rotating connection portion is rotatably connected to the frame connecting member.

A first slide groove is provided in the frame connecting member, and the first slide groove is provided with a component along a first direction, where the first direction is a direction perpendicular to a plane on which the first swing arm body is located. The second rotating connection portion is a cylindrical structure, and the second rotating connection portion is located in the first slide groove and is in movable fit with the first slide groove. In a process in which the first swing arm rotates relative to the base, the second rotating connection portion slides and rotates in the first slide groove.

According to a second aspect, an embodiment of this application further provides an electronic device, including a first device body, a second device body, and the hinge mechanism as described above. The first device body is connected to the second device body via the hinge mechanism.

In a process in which the first device body and the second device body rotate relative to each other, the electronic device switches between an unfolded state and a folded state.

In embodiments of this application, with external force acting on the frame connecting member, while rotating relative to the base, the frame connecting member drives the first swing arm to rotate relative to the base. However, because the first swing arm is rotatably connected to the frame connecting member via the cylindrical structure and the first slide groove, the first swing arm not only can rotate relative to the frame connecting member, but also slide relative to the frame connecting member. Moreover, the first slide groove is provided with a component along the first direction. In this case, in a process in which both the frame connecting member and the first swing arm rotate relative to the base, the first swing arm can generate a sliding displacement relative to the frame connecting member in the first direction. In this way, a rotation angle of the first swing arm relative to the base is reduced under the condition of ensuring a rotation angle of a frame, to improve rotation stability of the first swing arm. This helps improve folding reliability of the hinge mechanism.

### BRIEF DESCRIPTION OF DRAWINGS

FIG. 1 is a schematic diagram of a structure of a hinge mechanism according to an embodiment of this application;
FIG. 2 is a schematic diagram of a structure of a hinge mechanism according to an embodiment of this application from another perspective;
FIG. 3 is a schematic diagram of a partial structure of a hinge mechanism according to an embodiment of this application;
FIG. 4 is a cross-sectional view at A-A in FIG. 3;
FIG. 5 is a cross-sectional view at B-B in FIG. 3;
FIG. 6 is a cross-sectional view at C-C in FIG. 3;
FIG. 7 is a cross-sectional view at D-D in FIG. 3;
FIG. 8 is an exploded view of a partial structure of a hinge mechanism according to an embodiment of this application in an unfolded state;
FIG. 9 is an exploded view of a partial structure of a hinge mechanism according to an embodiment of this application in a folded state;
FIG. 10 is a cross-sectional view at A-A in FIG. 3 in a folding process of the hinge mechanism;
FIG. 11 is a cross-sectional view at C-C in FIG. 3 in a folding process of the hinge mechanism;
FIG. 12 is a schematic diagram of a structure of a first swing arm according to an embodiment of this application;
FIG. 13 is a schematic diagram of a structure of a frame connecting member according to an embodiment of this application;
FIG. 14 is a schematic diagram of a structure of a second swing arm according to an embodiment of this application;
FIG. 15 is a schematic diagram of a structure of an electronic device according to an embodiment of this application; and
FIG. 16 is a side view of an electronic device according to an embodiment of this application.

Description of reference numerals:
100-base, 110-arc-shaped slot, 120-rotation shaft,
200-first swing arm, 210-first swing arm body, 220-first rotating connection portion, 230-second rotating connection portion, 240-second slide groove, 250-limiting slot,
300-frame connecting member, 310-first slide groove, 320-limiting protrusion, 330-third slide groove, 340-fourth slide groove, 350-fifth slide groove,
410-second swing arm, a-first driving curved surface, 411-second swing arm body, 412-third rotating connection portion, 413-fourth rotating connection portion, 414-first slide rail,
420-third swing arm, c-third driving curved surface,
430-fourth swing arm, e-fifth driving curved surface,
510-first movable member, b-second driving curved surface, 520-second movable member, d-fourth driving curved surface, 530-third movable member, f-sixth driving curved surface,
600-elastic member,
700-pressing cover,
800-support plate,
910-first device body, 920-second device body,
X-first direction, Y-second direction, and Z-third direction.

### DESCRIPTION OF EMBODIMENTS

Technical solutions in embodiments of this application are clearly described below with reference to the accompanying drawings in embodiments of this application. It is clear that the described embodiments are some embodiments of this application, but not all embodiments. Based on embodiments in this application, all other embodiments obtained by those of ordinary skill in the art without creative efforts fall within the protection scope of this application.

Terms ''first'', ''second'', and the like in the specification and claims of this application are used to distinguish between similar objects, but are not used to describe a specific order or sequence. It should be understood that the data used in this way can be interchanged under appropriate circumstances, so that embodiments of this application can be implemented in a sequence other than those illustrated or described herein. Objects distinguished by ''first'', ''second'', and the like are usually of one type, and a quantity of objects is not limited. For example, there may be one or more first objects. In addition, ''and/or'' in the specification and claims indicates at least one of connected objects, and character ''/'' generally indicates that preceding and following related objects are in an ''or'' relationship.

A hinge mechanism and an electronic device provided in embodiments of this application are described in detail below using specific embodiments and application scenarios thereof with reference to the accompanying drawings.

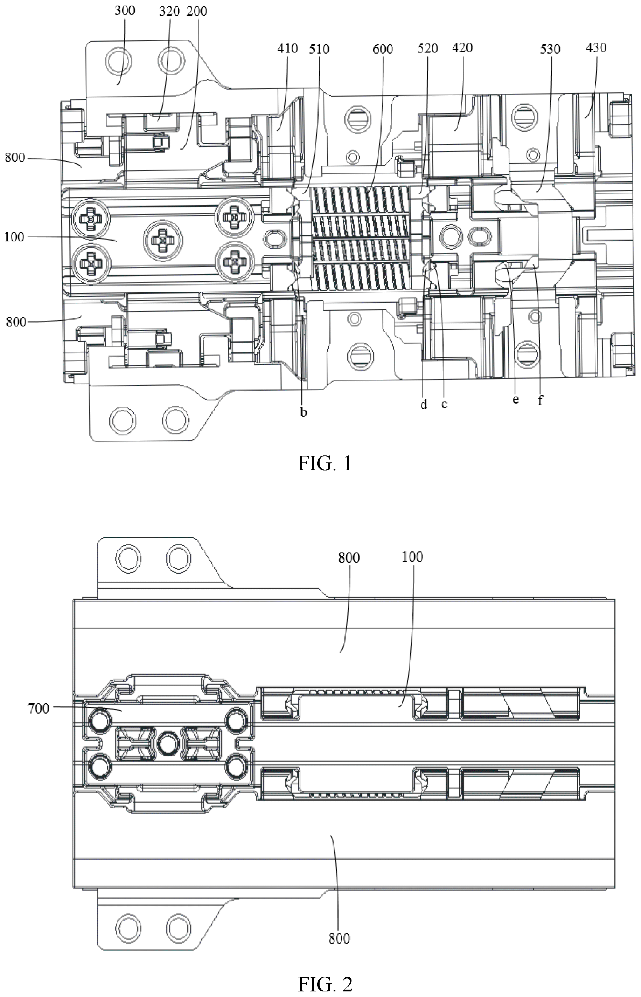

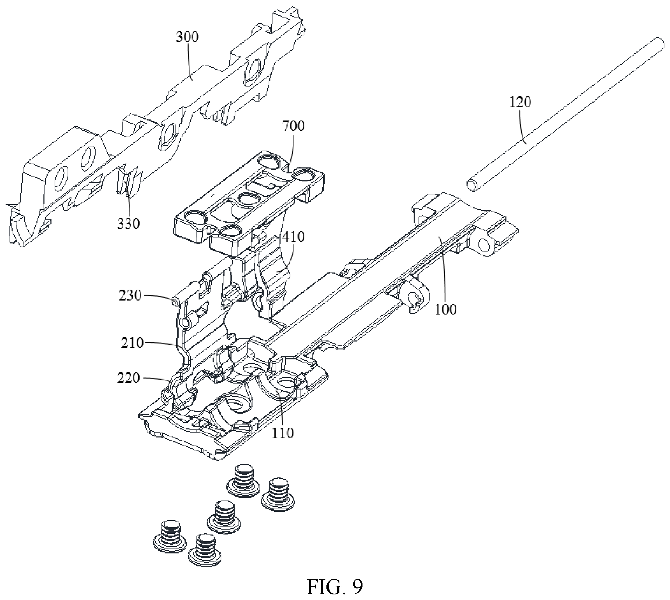

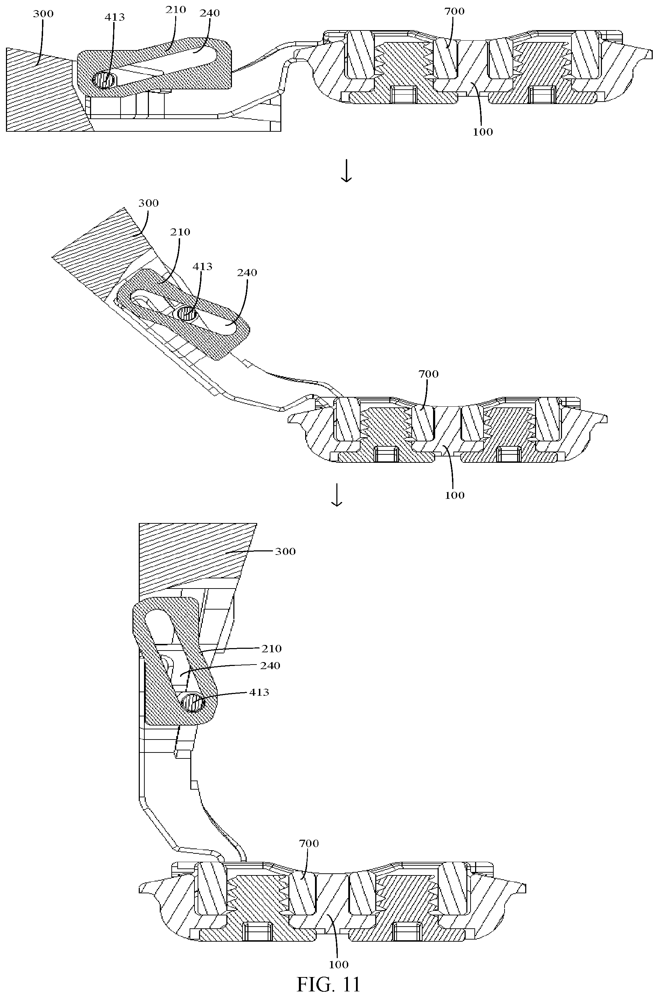

Refer to FIG. 1 to FIG. 16. A hinge mechanism disclosed in embodiments of this application is applied to an electronic device, and the electronic device is folded and unfolded via the hinge mechanism. The hinge mechanism includes a base 100, a first swing arm 200, and a frame connecting member 300. The base 100 is a foundation for mounting the first swing arm 200 and the frame connecting member 300. The first swing arm 200 is rotatably connected to the base 100. The frame connecting member 300 is rotatably connected to the first swing arm 200, and the frame connecting member 300 can drive the first swing arm 200 to rotate relative to the base 100.

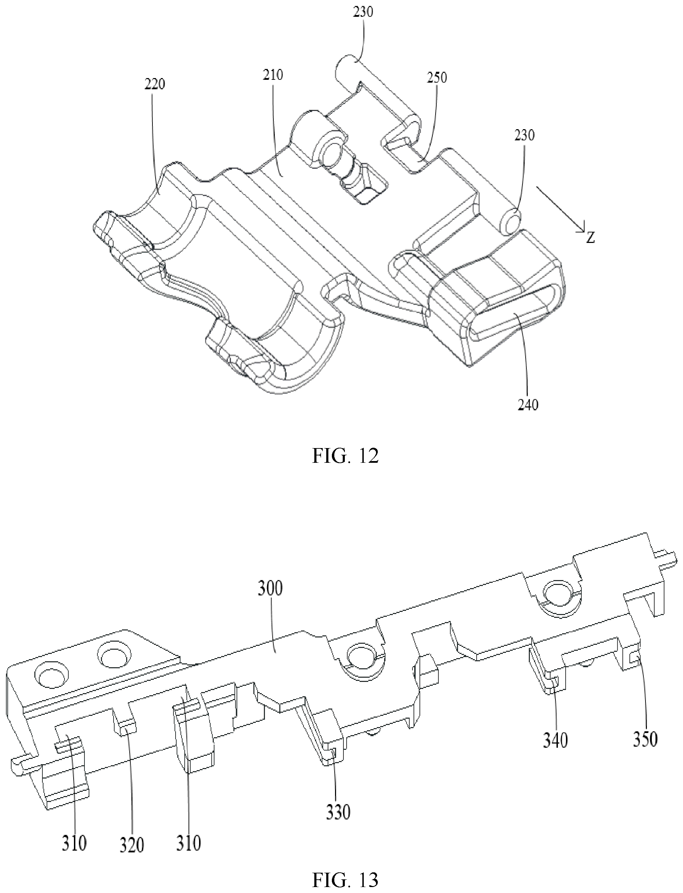

As shown in FIG. 12, the first swing arm 200 includes a first swing arm body 210, a first rotating connection portion 220, and a second rotating connection portion 230. Optionally, the first swing arm body 210, the first rotating connection portion 220, and the second rotating connection portion 230 may be an integral structure. The first swing arm body 210 is a foundation for disposing the first rotating connection portion 220 and the second rotating connection portion 230, the first rotating connection portion 220 and the second rotating connection portion 230 are disposed at two ends of the first swing arm body 210, the first rotating connection portion 220 is rotatably connected to the base 100, and the second rotating connection portion 230 is rotatably connected to the frame connecting member 300. Optionally, the hinge mechanism further includes a rotation shaft 120, the base 100 is connected to the rotation shaft 120, the first rotating connection portion 220 may be a cylindrical portion, and the outside of the rotation shaft 120 may be sleeved in the cylindrical portion, to achieve rotatable connection between the base 100 and the first rotating connection portion 220.

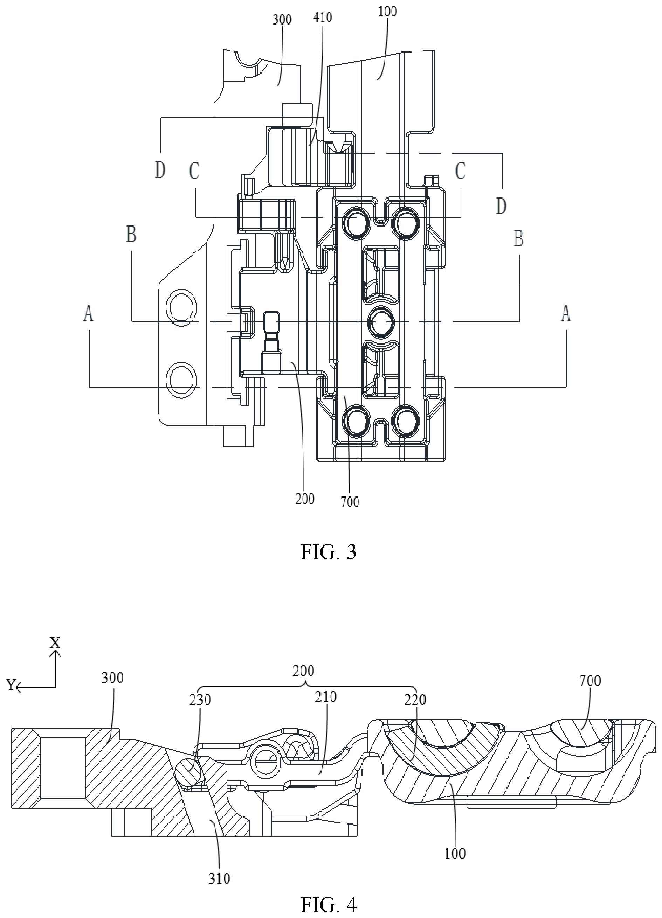

A first slide groove 310 is provided in the frame connecting member 300, and the first slide groove 310 is provided with a component along a first direction. The first direction is a direction perpendicular to a plane on which the first swing arm body 210 is located, and the first direction may refer to the "X" direction in FIG. 4. The second rotating connection portion 230 is a cylindrical structure, the second rotating connection portion 230 is located in the first slide groove 310 and is in movable fit with the first slide groove 310, and a surface of the cylindrical structure is in contact with a slot wall surface of the first slide groove 310. In a process in which the first swing arm 200 rotates relative to the base 100, the second rotating connection portion 230 slides and rotates in the first slide groove 310. That is, in a process in which the frame connecting member 300 drives the first swing arm 200 to rotate relative to the base 100, via the cylindrical structure and the first slide groove 310, the first swing arm 200 can generate a sliding displacement relative to the frame connecting member 300 in the first direction.

Optionally, the first slide groove 310 may be an arc-shaped structure, or may extend directly along the first direction, or may be a slide groove in another shape. This embodiment does not limit the structure of the first slide groove 310 provided that the first slide groove 310 is provided with a component along the first direction, ensuring that both the frame connecting member 300 and the first swing arm 200 can rotate smoothly relative to the base 100.

In embodiments of this application, with external force acting on the frame connecting member 300, while rotating relative to the base 100, the frame connecting member 300 drives the first swing arm 200 to rotate relative to the base 100. However, because the first swing arm 200 is rotatably connected to the frame connecting member 300 via the cylindrical structure and the first slide groove 310, the first swing arm 200 not only can rotate relative to the frame connecting member 300, but also slide relative to the frame connecting member 300. The fitting structure is simple, without disposing a separate adapter component between the first swing arm 200 and the frame connecting member 300, and the first slide groove 310 is provided with a component along the first direction. In this case, in a process in which both the frame connecting member 300 and the first swing arm 200 rotate relative to the base 100, the first swing arm 200 can generate a sliding displacement relative to the frame connecting member 300 in the first direction. In this way, a rotation angle of the first swing arm 200 relative to the base 100 is caused to be smaller than a rotation angle of the frame connecting member 300 relative to the base 100, to reduce the rotation angle of the first swing arm 200. This helps increase a mating area between the first swing arm 200 and the base 100. In addition, a rotation angle of the first swing arm 200 relative to the base 100 is reduced under the condition of ensuring a rotation angle of a frame, to improve rotation stability of the first swing arm 200. This helps improve folding reliability of the hinge mechanism.

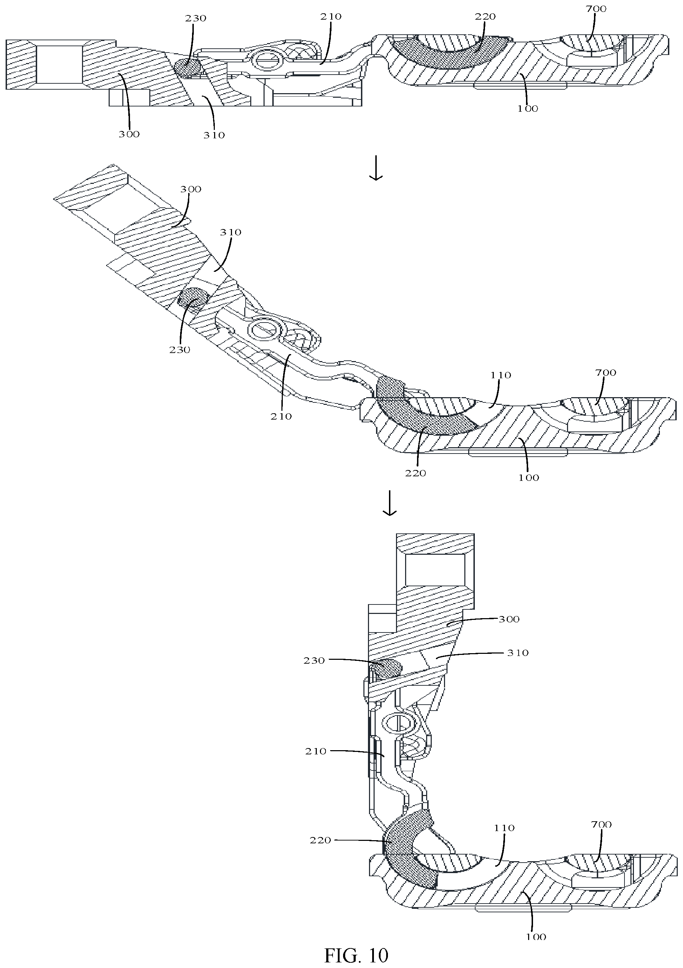

Moreover, it can be learned from FIG. 10 that due to the sliding displacement generated by the first swing arm 200 relative to the frame connecting member 300 in the first direction, in a folding process of the hinge mechanism, the first swing arm 200 can adjust its own position following a position of the frame connecting member 300. When the hinge mechanism is in a folded state, in a thickness direction of the hinge mechanism, space occupied by the first swing arm 200 basically overlaps with space occupied by the frame connecting member 300, that is, the first swing arm 200 does not protrude from the frame connecting member 300 at this time. Reducing space occupied by the first swing arm 200 and the frame connecting member 300 helps reduce thickness of the hinge mechanism in the folded state and make the hinge mechanism more lightweight and thinner.

In an optional embodiment, the first slide groove 310 may be provided with only a component along the first direction, that is, the first slide groove 310 extends directly along the first direction. In another embodiment, as shown in FIG. 4, the first slide groove 310 is further provided with a component along a second direction, the second direction is perpendicular to the first direction, and the second direction is perpendicular to a direction of an axis of the second rotating connection portion 230. The second direction may refer to the "Y" direction in FIG. 4. In this embodiment, in an unfolding process of the hinge mechanism, a position of the first swing arm 200 relative to the base 100 in the second direction remains unchanged while the frame connecting member 300 generates a sliding displacement relative to the first swing arm 200 in the second direction; as a result, the frame connecting member 300 generates a certain displacement relative to the base 100 along the second direction, and the frame connecting member 300 approaches the base 100 by a certain distance. In this way, in a width direction of the hinge mechanism, space occupied by the frame connecting member 300, the first swing arm 200, and the base 100 is reduced. This helps reduce a width of the hinge mechanism.

In an optional embodiment, as shown in FIG. 12, the second rotating connection portion 230 protrudes from a surface of the first swing arm body 210 in a third direction. The third direction is perpendicular to the first direction, and the third direction is parallel to a direction of an axis of the second rotating connection portion 230. The third direction may refer to the "Z" direction shown in FIG. 12. Optionally, the third direction is perpendicular to the first direction and the second direction mentioned above. In this embodiment, with the protruding direction of the second rotating connection portion 230 being different from a direction in which a second swing arm 410 and the frame connecting member 300 generate relative sliding in this embodiment, the second rotating connection portion 230 is not detached from the first slide groove 310 in a process in which the second swing arm 410 and the frame connecting member 300 slide relative to each other, ensuring continuous fitting between the second rotating connection portion 230 and the first slide groove 310.

Definitely, in the embodiment in which the first slide groove 310 is provided with only a component along the first direction, the second rotating connection portion 230 may alternatively protrude from the surface of the first swing arm body 210 in another direction. Optionally, the second rotating connection portion 230 may alternatively protrude from the surface of the first swing arm body 210 in the second direction.

In an optional embodiment, a difference between a slot width of the first slide groove 310 and a diameter of the second rotating connection portion 230 is within a preset range. Optionally, the preset range is a range between 0 and a preset value, and the preset value may be 0.05 mm or another value, and the preset value may be set as needed. To be specific, the slot width of the first slide groove 310 may be equal to the diameter of the second rotating connection portion 230, or the difference between the slot width of the first slide groove 310 and the diameter of the second rotating connection portion 230 may be less than the preset value.

A small gap between the second rotating connection portion 230 and the first slide groove 310 in this embodiment ensures stability of the second rotating connection portion 230 sliding and rotating in the first slide groove 310, and avoids the second rotating connection portion 230 from shaking in the first slide groove 310.

In an optional embodiment, as shown in FIG. 13, a limiting protrusion 320 is provided on the frame connecting member 300. As shown in FIG. 12, the first swing arm 200 is provided with a limiting slot 250, and the limiting protrusion 320 is in limiting fit with the limiting slot 250 in the extension direction of the first slide groove 310. Optionally, in the process in which the frame connecting member 300 and the first swing arm 200 rotate relative to the base 100, the limiting protrusion 320 can extend into the limiting slot 250, and the limiting protrusion 320 can contact the limiting slot 250 in a limiting manner.

With a position at which the first swing arm 200 and the frame connecting member 300 slide relative to each other via the limiting protrusion 320 and the limiting slot 250 being limited in this embodiment, a sliding displacement is small. This further prevents the second rotating connection portion 230 from sliding out of the first slide groove 310, ensuring stable connection between the frame connecting member 300 and the first swing arm 200.

Definitely, in another embodiment, no limiting protrusion 320 or limiting slot 250 may be provided in the frame connecting member 300 and the first swing arm 200, and the hinge mechanism may use another component to limit the position at which the frame connecting member 300 and the first swing arm 200 slide relative to each other.

In an optional embodiment, there is one second rotating connection portion 230 and one first slide groove 310.

In another embodiment, as shown in FIG. 12 and FIG. 13, there are at least two second rotating connection portions 230 and at least two first slide grooves 310, and the second rotating connection portions 230 correspond one-to-one to the first slide grooves 310. Two of the second rotating connection portions 230 are disposed back away from each other in the direction of the axis of the second rotating connection portion 230, and two of the first slide grooves 310 corresponding to two of the second rotating connection portions 230 are disposed facing each other.

With a plurality of second rotating connection portions 230 and a plurality of first slide grooves 310 disposed in this embodiment, different positions of the frame connecting member 300 are caused to rotatably connect to different positions of the first swing arm 200, respectively. This helps improve stability of connection between the frame connecting member 300 and the first swing arm 200 and enhance reliability of the hinge mechanism. In addition, two first slide grooves 310 disposed facing each other make the first swing arm 200 be in limiting fit with the frame connecting member 300 in two opposite directions of the axis of the second rotating connection portion 230, so that the second rotating connection portion 230 is not detached from the corresponding first slide groove 310.

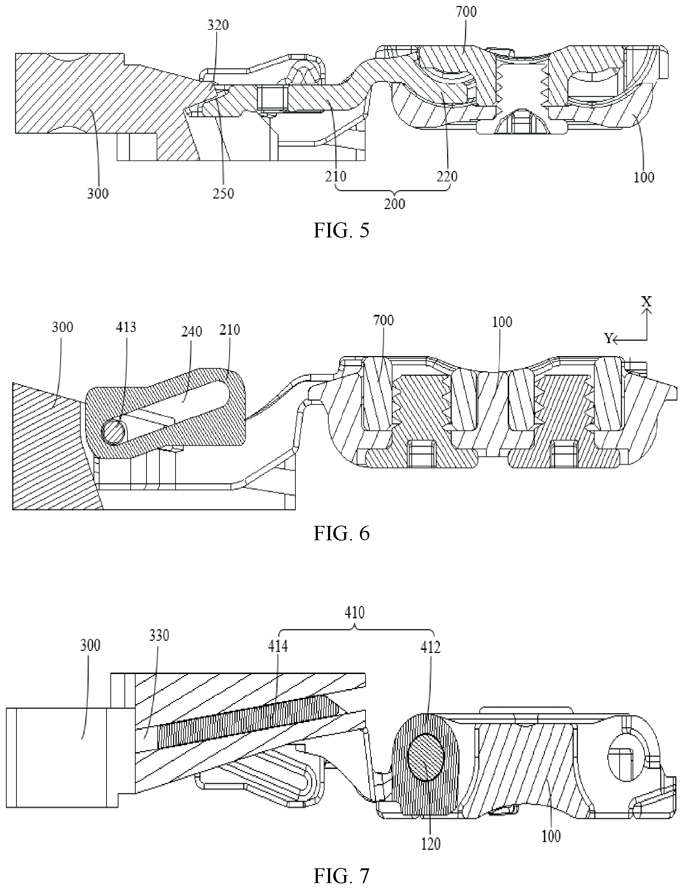

In a further embodiment, as shown in FIG. 5, a limiting protrusion 320 is located between two of the first slide grooves 310 that are disposed facing each other, and a limiting slot 250 is located between two of the second rotating connection portions 230 that are disposed back away from each other. The limiting protrusion 320 and the limiting slot 250 in this embodiment can simultaneously limit the two groups of first slide grooves 310 and second rotating connection portions 230 that fit with each other in pair, so that the two limiting protrusions 320 are not detached from the corresponding first slide grooves 310.

Definitely, in other embodiments, the limiting protrusion 320 and the limiting slot 250 may alternatively be disposed in other positions.

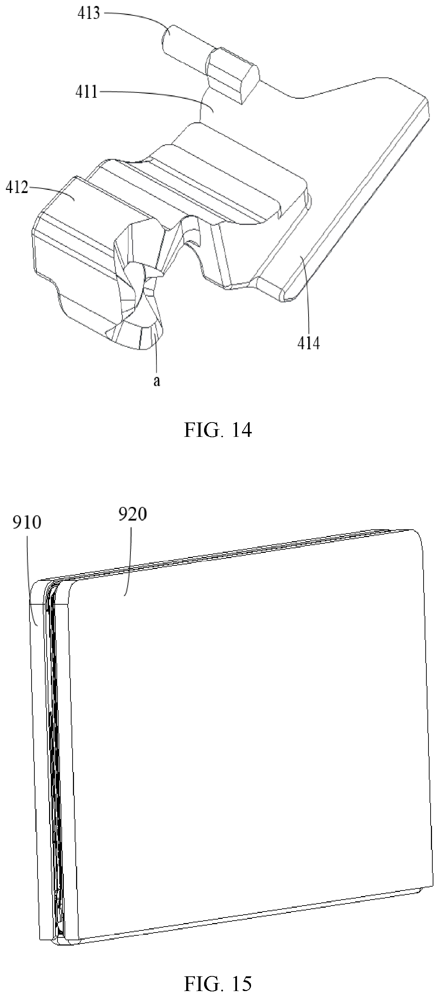

In an optional embodiment, the hinge mechanism further includes a second swing arm 410. As shown in FIG. 14, the second swing arm 410 includes a second swing arm body 411, a third rotating connection portion 412, and a fourth rotating connection portion 413. The second swing arm body 411 is a foundation for disposing the third rotating connection portion 412 and the fourth rotating connection portion 413. The third rotating connection portion 412 and the fourth rotating connection portion 413 are disposed at two ends of the second swing arm body 411. The third rotating connection portion 412 is rotatably connected to the base 100. Optionally, the hinge mechanism further includes a rotation shaft 120, the rotation shaft 120 is connected to the base 100, the outside of the rotation shaft 120 is sleeved in the third rotating connection portion 412, and the second swing arm 410 can rotate relative to the rotation shaft 120. In addition, the second swing arm body 411 is slidably connected to the frame connecting member 300, the fourth rotating connection portion 413 is movably connected to the first swing arm body 210, and the second swing arm 410 slides and rotates relative to the first swing arm 200 under the condition of the frame connecting member 300 driving the second swing arm 410 to rotate relative to the base 100. Optionally, the second swing arm body 411, the third rotating connection portion 412, and the fourth rotating connection portion 413 may be an integral structure.

A second slide groove 240 is provided in the first swing arm body 210, and the second slide groove 240 is provided with components along the first direction and a second direction. The second direction is perpendicular to the first direction, and the second direction is perpendicular to the direction of the axis of the second rotating connection portion 230. The fourth rotating connection portion 413 is a cylindrical structure, the fourth rotating connection portion 413 is located in the second slide groove 240 and is in movable fit with the second slide groove 240, and a surface of the cylindrical structure is in contact with a slot wall surface of the second slide groove 240. Under the case of the second swing arm 410 rotating relative to the base 100, the fourth rotating connection portion 413 slides and rotates in the second slide groove 240. That is, in a process in which the frame connecting member 300 drives the second swing arm 410 to rotate relative to the base 100, with the cylindrical structure and the second slide groove 240, the second swing arm 410 can generate sliding displacements relative to the first swing arm 200 in the first direction and the second direction.

Optionally, the second slide groove 240 may be an arc-shaped structure, a linear structure, or a slide groove in another shape. This embodiment does not limit the structure of the second slide groove 240, provided that the second slide groove 240 is provided with components along the first direction and the second direction and ensures smooth movement of the second swing arm 410 relative to the first swing arm 200.

On the basis of the second swing arm 410 and the first swing arm 200 being rotatably connected to the frame connecting member 300 in this embodiment, the second swing arm 410 is further movably connected to the first swing arm 200, to improve connection stability and effectively avoid problems such as shaking of the first swing arm 200 in a movement process. In addition, with the second swing arm 410 and the first swing arm 200 sliding and rotating relative to each other, a normal movement process of the second swing arm 410 and the first swing arm 200 relative to the frame connecting member 300 cannot be affected. Moreover, with the simple fitting structure of the second slide groove 240 and the fourth rotating connection portion 413, no separate adapter piece needs to be disposed between the first swing arm 200 and the second swing arm 410. This helps simplify the structure of the hinge mechanism.

In an optional embodiment, as shown in FIG. 7, a third slide groove 330 is provided in one of the frame connecting member 300 and the second swing arm body 411, and a first slide rail 414 is provided on the other of the frame connecting member 300 and the second swing arm body 411. The first slide rail 414 extends into the third slide groove 330, and the first slide rail 414 is in sliding fit with the third slide groove 330. Optionally, the third slide groove 330 may be provided in the frame connecting member 300, and first slide rail 414 is provided on the second swing arm body 411; or the first slide rail 414 is provided on the frame connecting member 300, and the third slide groove 330 is provided in the second swing arm body 411. In this way, with the third slide groove 330 and first slide rail 414 fitting with each other, the frame connecting member 300 and the second swing arm body 411 directly slide relative to each other, without disposing a complex sliding connection structure.

Optionally, as shown in FIG. 14, the fourth rotating connection portion 413 is disposed back away from the first slide rail 414.

Definitely, in another embodiment, the frame connecting member 300 may alternatively be slidably connected to the second swing arm body 411 by using another method.

In the solution of this application, as shown in FIG. 1, the hinge mechanism further includes a first movable member 510 and an elastic member 600. A first driving curved surface a is provided on the third rotating connection portion 412, and a second driving curved surface b is provided on the first movable member 510. The first driving curved surface a and the second driving curved surface b fit with each other. The first movable member 510 is connected to the elastic member 600. When the third rotating connection portion 412 rotates, the first movable member 510 is driven to move through the first driving curved surface a and the second driving curved surface b. The first movable member 510 acts on the elastic member 600 to cause the elastic member 600 to undergo elastic deformation. The elastic member 600 may be, but is not limited to, a spring. Optionally, the outside of the rotation shaft 120 may be sleeved in the elastic member 600. Optionally, each of the first driving curved surface a and the second driving curved surface b includes a plurality of first concave surfaces and a plurality of first convex surfaces. The first concave surfaces and the first convex surfaces are alternately distributed in a circumferential direction of the third rotating connection portion 412.

With the second swing arm 410 driving the first movable member 510 during rotation to move in this embodiment, the elastic member 600 generates an elastic deformation amount. Elastic force generated by the elastic member 600 acts reversely on the second swing arm 410, increasing damping force borne by the second swing arm 410 in the rotation process, improving damping effect of the hinge mechanism, and facilitating the hinge mechanism to maintain at a certain folding angle.

In an optional embodiment, the hinge mechanism further includes a third swing arm 420 and a second movable member 520. The third swing arm 420 is rotatably connected to the base 100, and the third swing arm 420 is slidably connected to the frame connecting member 300. Optionally, the outside of the rotation shaft 120 is sleeved in the third swing arm 420, and the third swing arm 420 can rotate around the rotation shaft 120. A fourth slide groove 340 is provided in one of the third swing arm 420 and the frame connecting member 300, and a second slide rail is provided on the other of the third swing arm 420 and the frame connecting member 300. The second slide rail extends into the fourth slide groove 340, and the second slide rail is in sliding fit with the fourth slide groove 340.

A third driving curved surface c is provided on the third swing arm 420, and a fourth driving curved surface d is provided on the second movable member 520. The third driving curved surface c and the fourth driving curved surface d fit with each other. During rotation, the third swing arm 420 drives the second movable member 520 through the third driving curved surface c and the fourth driving curved surface d to move. Both the third swing arm 420 and the second movable member 520 are located on a side that is of the elastic member 600 and that faces away from the second swing arm body 411, and the second movable member 520 is located between the elastic member 600 and the third swing arm 420. In this way, a moving direction of the first movable member 510 is opposite a moving direction of the second movable member 520, and the first movable member 510 and the second movable member 520 act on two ends of the same elastic member 600, respectively.

Optionally, each of the third driving curved surface c and the fourth driving curved surface d includes a plurality of second concave surfaces and a plurality of second convex surfaces. The second concave surfaces and the second convex surfaces are alternately distributed in a circumferential direction of a rotation axis of the third swing arm 420 relative to the base 100.

With the second movable member 520 and the third swing arm 420 added in this embodiment, both the first movable member 510 and the second movable member 520 can act on the same elastic member 600. This helps increase an elastic deformation amount of the elastic member 600 and further improve damping effect of the hinge mechanism. In addition, the first movable member 510 and the second movable member 520 do not need to act on different elastic members 600. This helps reduce a quantity of components in the hinge mechanism and simplify the structure of the hinge mechanism.

In an optional embodiment, the hinge mechanism further includes a fourth swing arm 430 and a third movable member 530. The fourth swing arm 430 is rotatably connected to the base 100. Optionally, the outside of the rotation shaft 120 is sleeved in the fourth swing arm 430, and the fourth swing arm 430 can rotate around the rotation shaft 120. In addition, the fourth swing arm 430 is slidably connected to the frame connecting member 300. Optionally, a fifth slide groove 350 is provided in one of the fourth swing arm 430 and the frame connecting member 300, and a third slide rail is provided on the other of the fourth swing arm 430 and the frame connecting member 300. The third slide rail extends into the fifth slide groove 350, and the third slide rail is in sliding fit with the fifth slide groove 350. Both the fourth swing arm 430 and the third movable member 530 are located on a side that is of the third swing arm 420 and that faces away from the second swing arm 410, and the third movable member 530 is located between the third swing arm 420 and the fourth swing arm 430.

A fifth driving curved surface e is further provided on the fourth swing arm 430, and a sixth driving curved surface f is provided on the third movable member 530. The fifth driving curved surface e and the sixth driving curved surface f fit with each other. During rotation, the fourth swing arm 430 drives the third movable member 530 through the fifth driving curved surface e and the sixth driving curved surface f to move. In addition, a seventh driving curved surface is provided on the third movable member 530, and an eighth driving curved surface is further provided on the fourth swing arm 430. The seventh driving curved surface and the eighth driving curved surface fit with each other. During movement, the third movable member 530 drives the fourth swing arm 430 through the seventh driving curved surface and the eighth driving curved surface to rotate. A moving direction of the third movable member 530 is the same as a moving direction of the first movable member 510.

Optionally, each of the fifth driving curved surface e, the sixth driving curved surface f, the seventh driving curved surface, and the eighth driving curved surface includes a plurality of third concave surfaces and a plurality of third convex surfaces. The third concave surfaces and the third convex surfaces are alternately distributed in a circumferential direction of a rotation axis of the fourth swing arm 430 relative to the base 100.

With the third swing arm 420, the third movable member 530, and the fourth swing arm 430 fitting in sequence in this embodiment, when the third swing arm 420 acts on the third movable member 530, the third movable member 530 moves and drives the fourth swing arm 430 to rotate. Similarly, when the fourth swing arm 430 acts on the third movable member 530, the third movable member 530 moves and drives the third swing arm 420 to rotate. This helps achieve the overall rotation of the frame connecting member 300 relative to the base 100 and facilitate smooth folding and unfolding of the hinge mechanism.

In an optional embodiment, the first rotating connection portion 220 is an arc-shaped protrusion, and an arc-shaped slot 110 is provided in the base 100. The arc-shaped protrusion extends into the arc-shaped slot 110, and the arc-shaped protrusion is in sliding fit with the arc-shaped slot 110, so that the first swing arm 200 rotates relative to the frame connecting member 300. Optionally, as shown in FIG. 10, under the condition of the hinge mechanism being in an unfolded state, the entire arc-shaped protrusion is located within the arc-shaped slot 110. In a process in which the hinge mechanism switches from the unfolded state to a folded state, a part, extending out of the arc-shaped slot 110, of the arc-shaped protrusion increases.

With the arc-shaped protrusion and the arc-shaped slot 110 in this embodiment, the first swing arm 200 is rotatably connected to the base 100, without disposing a complex sleeve structure. This simplifies a structure of connection between the first swing arm 200 and the base 100. In addition, in a process in which the first swing arm 200 rotates relative to the base 100, an angle of rotation of the first swing arm 200 relative to the base 100 is reduced, and a part, extending out of the arc-shaped slot 110, of the arc-shaped protrusion decreases. In this case, a central angle corresponding to a portion, located within the arc-shaped slot 110, of the arc-shaped protrusion increases. This helps increase a mating area between the first swing arm 200 and the base 100 and improve stability of the first swing arm 200.

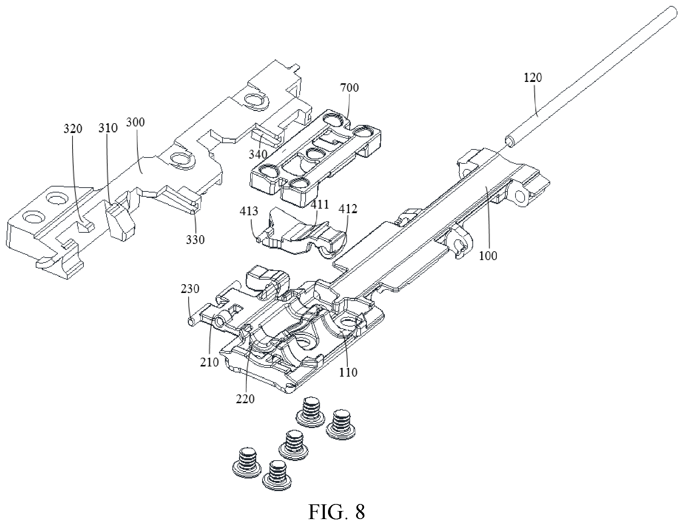

In an optional embodiment, as shown in FIG. 1 and FIG. 8, the hinge mechanism further includes a pressing cover 700. The pressing cover 700 is disposed on a side that is of the first rotating connection portion 220 and that faces away from the base 100, the pressing cover 700 is connected to the base 100, and the pressing cover 700 presses the first rotating connection portion 220 against the base 100. Optionally, the pressing cover 700 and the base 100 may be fastened using threaded fasteners such as screws. Definitely, the pressing cover 700 and the base 100 may alternatively be fastened by using other methods such as welding. Optionally, the first rotating connection portion 220 is an arc-shaped protrusion, and an arc-shaped slot 110 is provided in the base 100. As shown in FIG. 4, a surface that is of the pressing cover 700 and that faces the arc-shaped protrusion is an arc surface, an outer surface of the arc-shaped protrusion is in contact with a slot wall surface of the arc-shaped slot 110, an inner surface of the arc-shaped slot 110 is in contact with the arc surface of the pressing cover 700, and the pressing cover 700 does not affect the relative sliding of the arc-shaped protrusion and the arc-shaped slot 110.

Pressing first rotating connection portion 220 against the base 100 using the pressing cover 700 in this embodiment helps improve stability of the first swing arm 200 and avoid shaking of the first swing arm 200 relative to the base 100. In addition, in the embodiment in which the first rotating connection portion 220 is rotatably connected to the base 100 via the arc-shaped protrusion and the arc-shaped slot 110, the pressing cover 700 can close a slot opening corresponding to the arc-shaped slot 110, avoiding breaks in the base 100. This helps improve rigidity performance and support performance of the hinge mechanism.

In an optional embodiment, as shown in FIG. 2, the hinge mechanism further includes a support plate 800. The support plate 800 is located on a side of the base 100, the support plate 800 is connected to the frame connecting member 300, and the support plate 800 is slidably connected to the first swing arm 200. Optionally, under the condition of the hinge mechanism being in the unfolded state, the support plate 800 and the base 100 are on a same plane. The support plate 800 in this embodiment can shield the first swing arm 200 and the frame connecting member 300, avoiding direct exposure of the first swing arm 200 and the frame connecting member 300. This helps improve appearance performance of the hinge mechanism.

In an optional embodiment, a rotation shaft 120, a first swing arm 200, a second swing arm 410, a third swing arm 420, a fourth swing arm 430, a frame connecting member 300, and a support plate 800 are disposed on each of two sides of the base 100. In addition, a first movable member 510 fits with the two second swing arms 410, a second movable member 520 fits with the two third swing arms 420, and a third movable member 530 fits with the two third swing arms 420 and the two fourth swing arms 430. The first swing arm 200 is a virtual swing arm in the prior art, and the second swing arm 410, the third swing arm 420, and the fourth swing arm 430 are synchronous swing arms in the prior art.

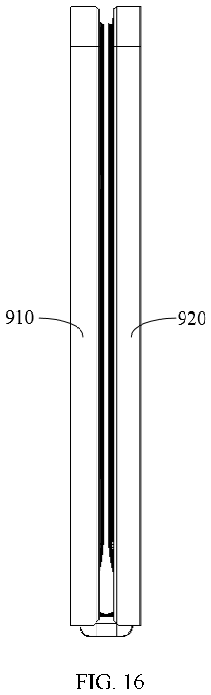

Based on the hinge mechanism disclosed in this application, an embodiment of this application further provides an electronic device. As shown in FIG. 15 and FIG. 16, the electronic device includes a first device body 910, a second device body 920, and the hinge mechanism in the above embodiments. The first device body 910 is connected to the second device body 920 via the hinge mechanism. In the process in which the first device body 910 and the second device body 920 rotate relative to each other, the electronic device switches between an unfolded state and a folded state. Optionally, a first swing arm 200 and a frame connecting member 300 are disposed on each of two sides of the base 100, and the first device body 910 and the second device body 920 are connected to the frame connecting members 300 located on the two sides of the base 100, respectively. With this arrangement, the hinge mechanism of the electronic device can improve stability of the first swing arm 200. This helps improve folding reliability of the electronic device.

Embodiments of this application are described above with reference to the accompanying drawings, but this application is not limited to the specific embodiments described above. The specific embodiments described above are only illustrative but not restrictive. Many forms that persons of ordinary skill in the art can derive under the inspiration of this application without departing from the spirit of this application and the protection scope of the claims shall all fall within the protection scope of this application.

## Claims

1. A hinge mechanism, comprising a base, a first swing arm, and a frame connecting member, wherein
the first swing arm comprises a first swing arm body, a first rotating connection portion, and a second rotating connection portion, the first rotating connection portion and the second rotating connection portion are disposed at two ends of the first swing arm body, the first rotating connection portion is rotatably connected to the base, and the second rotating connection portion is rotatably connected to the frame connecting member; and
a first slide groove is provided in the frame connecting member, and the first slide groove is provided with a component along a first direction, wherein the first direction is a direction perpendicular to a plane on which the first swing arm body is located; the second rotating connection portion is a cylindrical structure, and the second rotating connection portion is located in the first slide groove and is in movable fit with the first slide groove; and in a process in which the first swing arm rotates relative to the base, the second rotating connection portion slides and rotates in the first slide groove.

2. The hinge mechanism according to claim 1, wherein the first slide groove is further provided with a component along a second direction, the second direction is perpendicular to the first direction, and the second direction is perpendicular to a direction of an axis of the second rotating connection portion.

3. The hinge mechanism according to claim 1, wherein the second rotating connection portion protrudes from a surface of the first swing arm body in a third direction, the third direction is perpendicular to the first direction, and the third direction is parallel to a direction of an axis of the second rotating connection portion.

4. The hinge mechanism according to claim 1, wherein a difference between a slot width of the first slide groove and a diameter of the second rotating connection portion is within a preset range.

5. The hinge mechanism according to claim 1, wherein a limiting protrusion is provided on the frame connecting member, a limiting slot is provided in the first swing arm, and the limiting protrusion is in limiting fit with the limiting slot in an extension direction of the first slide groove.

6. The hinge mechanism according to claim 5, wherein quantities of the second rotating connection portions and the first slide grooves are each at least two, the second rotating connection portions correspond one-to-one to the first slide grooves, two of the second rotating connection portions are disposed back away from each other in a direction of an axis of the second rotating connection portion, and two of the first slide grooves corresponding to two of the second rotating connection portions are disposed facing each other.

7. The hinge mechanism according to claim 6, wherein the limiting protrusion is located between two of the first slide grooves that are disposed facing each other, and the limiting slot is located between two of the second rotating connection portions that are disposed back away from each other.

8. The hinge mechanism according to claim 1, wherein the hinge mechanism further comprises a second swing arm, the second swing arm comprises a second swing arm body, a third rotating connection portion, and a fourth rotating connection portion, the third rotating connection portion and the fourth rotating connection portion are disposed at two ends of the second swing arm body, the third rotating connection portion is rotatably connected to the base, the second swing arm body is slidably connected to the frame connecting member, and the fourth rotating connection portion is movably connected to the first swing arm body; and
a second slide groove is provided in the first swing arm body, the second slide groove is provided with components along the first direction and a second direction, the second direction is perpendicular to the first direction, and the second direction is perpendicular to a direction of an axis of the second rotating connection portion, the fourth rotating connection portion is a cylindrical structure, and the fourth rotating connection portion is located in the second slide groove and is in movable fit with the second slide groove; and under the condition of the second swing arm rotating relative to the base, the fourth rotating connection portion slides and rotates in the second slide groove.

9. The hinge mechanism according to claim 8, wherein a third slide groove is provided in one of the frame connecting member and the second swing arm body, and a first slide rail is provided on the other of the frame connecting member and the second swing arm body, the first slide rail extends into the third slide groove, and the first slide rail is in sliding fit with the third slide groove.

10. The hinge mechanism according to claim 1, wherein the first rotating connection portion is an arc-shaped protrusion, an arc-shaped slot is provided in the base, the arc-shaped protrusion extends into the arc-shaped slot, and the arc-shaped protrusion is in sliding fit with the arc-shaped slot.

11. The hinge mechanism according to claim 1, wherein the hinge mechanism further comprises a pressing cover, the pressing cover is disposed on a side that is of the first rotating connection portion and that faces away from the base, and the pressing cover is connected to the base.

12. An electronic device, comprising a first device body, a second device body, and the hinge mechanism according to any one of claims 1 to 11, wherein the first device body is connected to the second device body via the hinge mechanism; and
in a process in which the first device body and the second device body rotate relative to each other, the electronic device switches between an unfolded state and a folded state.
